# EUROPEAN PATENT SPECIFICATION

(11) **EP 1 306 889 B1**
(45) Date of publication and mention of the grant of the patent: **17.01.2007**
(21) Application number: 02252255.1
(22) Date of filing: 27.03.2002
(51) Int. Cl.: H01L 21/02, H01L 21/8247, H01L 27/115, H01L 29/92

(54) **Electronic device with electrode and its manufacture**
Elektronische Anordnung mit einer Elektrode und ihre Herstellung
Dispositif électronique avec une électrode et sa fabrication

(30) Priority: 26.10.2001 JP 2001329688
(43) Date of publication of application: 02.05.2003
(73) Proprietor: FUJITSU LIMITED, Kawasaki-shi, Kanagawa 211-8588 (JP)
(72) Inventor: Maruyama, Kenji, c/o Fujitsu Limited, Kawasaki-shi, Kanagawa 211-8588 (JP); Kondo, Masao, c/o Fujitsu Limited, Kawasaki-shi, Kanagawa 211-8588 (JP); Kurusawa, Masaki, c/o Fujitsu Limited, Kawasaki-shi, Kanagawa 211-8588 (JP)
(74) Representative: Fenlon, Christine Lesley

(56) References cited:
- EP-A- 0 795 898
- EP-A- 0 957 516
- US-A- 5 192 723
- US-A- 5 514 484
- US-A- 5 623 439
- US-A1- 2001 005 026
- US-B1- 6 194 753
- P. C. VAN BUSKIRK ET AL.: "Common and Unique Aspects of Perovskite Thin Film CVD Processes" INTEGRATED FERROELECTRICS, vol. 21, 1998, pages 273-289, XP008031718

## Description

The present invention relates to an electronic device having a ferroelectric layer and a method of manufacturing the same, more particularly to an electronic device having a ferroelectric layer oriented crystallographically and a method of manufacturing the same.

Devices having ferroelectric layers oriented crystallographically are known. For example, US 5,514,484 discloses a device having an ABO₃ type perovskite ferroelectric layer formed on an orientative buffer layer which also has perovskite structure.

A semiconductor memory, in which one memory cell comprises one transistor and one capacitor, is known in the art. A Dynamic Random Access Memory (DRAM) capacitor contains a capacitor dielectric layer formed of a paraelectric material. Electric charges stored in the capacitor gradually decline due to discharge, even when the transistor is turned off. Accordingly, removal of an applied voltage to the memory cell causes information stored therein to decrease and disappear with time.

A memory device capable of retaining information stored therein, even after power is cut off, is called a non-volatile memory. One known type of non-volatile memory, a one-transistor/one-capacitor type memory has a capacitor dielectric layer formed of a ferroelectric material and is termed a ferroelectric Random Access Memory (FeRAM).

The FeRAM utilizes residual polarization of the ferroelectric material to store information therein. The FeRAM controls the polarity of a voltage applied between a pair of electrodes of the ferroelectric capacitor, thus controlling the direction of the residual polarization. Assuming that one polarization direction be "1" and the other be "0", binary information can be stored. Since the residual polarization remains in the ferroelectric capacitor, even after the applied voltage is removed therefrom, the non-volatile memory can be re-accessed. The non-volatile memory enables information to be rewritten a large number of times, i.e. 10¹⁰ to 10¹² times. The non-volatile memory also has a rewriting speed of an order of several tens of nanoseconds and offers a high-speed operability.

Ferroelectric materials such as lead-based oxide ferroelectric materials having a perovskite structure and bismuth-based oxide ferroelectric materials having a bismuth-layered structure are known. Typical examples of the lead-based ferroelectric materials are PbZrₓTi₁₋ₓO₃ (PZT), Pb_{y}La_{1-y}ZrₓTi₁₋ₓO₃ (PLZT) and the like. A typical example of the bismuth-based oxide ferroelectric materials is SrBi₂Ta₂O₉(BST).

The ferroelectric capacitor offers a higher charge retention capability as the polarization of the ferroelectric material is greater, and can retain the electric potential with less capacitance.
Specifically, the FeRAM may be fabricated with high integration. Furthermore, as the level of polarization of the ferroelectric material is greater, the polarization directions can be differentiated more clearly even at a low reading-out voltage, thus enabling the ferroelectric memory to be driven at a low voltage.

It is effective to arrange orientations of ferroelectric crystals uniformly in order to increase a polarization amount of the ferroelectric material. For example, the Journal of Applied Physics 1991, vol. 70, No. 1 on pages 382 to 388 discloses a method of obtaining a (111)-oriented ferroelectric thin film, in which metal thin films, formed of metals such as platinum (Pt) and iridium (Ir), are deposited at 500°C to obtain a (111)-oriented metal thin film, and a ferroelectric thin film, such as PZT, is deposited thereon at room temperature, followed by heating of the deposited ferroelectric thin film to a range from 650°C to 700°C. However, the maximum temperature permitted for a manufacturing process of the FeRAM is usually 620°C.

A ferroelectric material, such as PZT, having simple tetragonal perovskite structure, a polarization axis along the c axis, <100> direction. Accordingly, the polarization amount is at a maximum when the ferroelectric layer is oriented approximately along a (001) plane (hereinafter, referred to as (001)-oriented). When the ferroelectric layer is (111)-oriented, a component of the polarization produced in the <100> direction is only about 1/1.73 of that in <111> direction, the thickness direction of the ferroelectric layer. Although the polarization can be increased by aligning orientation, it is impossible to increase the polarization to the maximum.

An object of the present invention is to provide an electronic device with a ferroelectric layer having a large degree of polarization and a method of manufacturing the same.

According to one aspect of the present invention, there is provided an electronic device comprising: an underlying body including an amorphous layer and a MgO layer, said MgO layer being formed on said amorphous layer and having a (001) orientated surface; a ReO₃ layer formed on said MgO layer and having a (001) orientation; and an oxide ferroelectric layer having a perovskite structure, said oxide ferroelectric layer being formed on said ReO₃ layer and having a (001) orientation.

According to another aspect of the present invention, there is provided a method of manufacturing an electronic device, comprising the sequential steps of: (1) preparing an amorphous layer;(2) forming a MgO layer having an (001) orientation on said amorphous layer; (3) forming an ReO₃ layer having a (001) orientation on said MgO layer; and (4) forming an oxide ferroelectric layer, having a perovskite structure and a (001) orientation, on said ReO₃ layer.

Lattice matching can be made for the (001)-oriented ReO₃ layer and the (001)-oriented oxide ferroelectric layer having a perovskite structure; accordingly, the (001)-oriented oxide ferroelectric layer having a perovskite structure can be formed on the (001)-oriented ReO₃ layer.

The MgO layer can be (001)-oriented with ease. Lattice matching can be made for both the (001)-oriented MgO layer and the (001)-oriented ReO₃ layer. Hence, the (001)-oriented ReO₃ layer and the (001)-oriented oxide ferroelectric layer having a perovskite structure can be formed sequentially on the (001)-oriented MgO layer.

The term "ReO₃ layer" used herein includes ReO₃ to which metal other than Re is added, for example, for controlling a lattice constant thereof.

In such a manner as described above, it is possible to form a ferroelectric capacitor capable of greater levels of polarization.

Reference will be made hereinafter to the drawings, wherein:
Fig. 1A is a schematic cross-sectional view of an electronic device according to the present invention;
Fig. 1B is a schematic block diagram showing an arrangement of a Organometallic Chemical Vapour Deposition (MOCVD) apparatus; Fig. 1C is a schematic cross-sectional view showing an upper electrode of the electronic device according to the present invention when a stacked structure is adopted; and Fig. 1D is a schematic cross-sectional view of the electronic device according to the present invention when a single crystal MgO layer is used;
Figs. 2A and 2B are structural views showing the chemical formulae of Mg(DPM)₂ and i-PrO.
Figs. 3A and 3B are cross-sectional view of an electronic device having a ferroelectric capacitor according to the present invention.

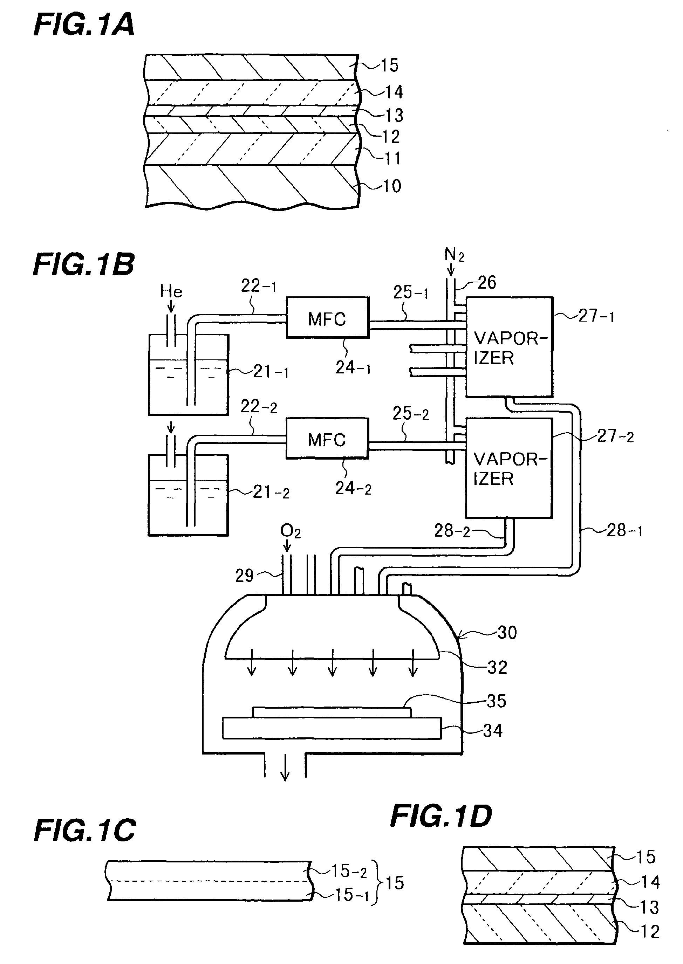

Fig. 1A shows the structure of a ferroelectric capacitor according to a first embodiment of the present invention. A silicon oxide layer 11 is formed on an Si substrate 10. The silicon oxide layer 11 may be formed, for example, by thermal oxidation of silicon or Chemical Vapour Deposition (CVD). The silicon oxide layer 11 is of an amorphous character. A (001)-oriented MgO layer 12 is formed on the silicon oxide layer 11, a (001)-orientated ReO₃ layer 13 is formed on the MgO layer 12, a (001)-oriented PZT layer 14 is formed on the ReO₃ layer 13. All the aforesaid layers 12, 13 and 14 can be deposited by Organometallic Chemical Vapour Deposition (MOCVD) using an organometallic material.

Fig. 1B schematicaly shows an arrangement of an apparatus for depositing a film by MOCVD. A liquid container 21-1 contains a solution of the organometallic material to be deposited. Pressurized He gas is fed to the liquid container 21-1 via a pipe terminating above the solution. A second pipe 22-1 has an end portion immersed in the solution to allow the solution to flow into the container 21-1. The flow rate of the supplied solution is controlled by a Mass Flow Controller (MFC) 24-1, and the solution is supplied to a vapourizer 27-1 through a pipe 25-1.

A carrier gas pipe 26 is connected to the vapourizer 27-1. The raw material liquid supplied to the vapourizer 27-1 together with carrier gas N₂ is vapourized by the vapourizer 27-1 and supplied to a pipe 28-1.

A liquid container 21-2, a pipe 22-2, a mass flow controller 24-2, a pipe 25-2, a vapourizer 27-2 and a pipe 28-2 have similar structures as those of the liquid container 21-1, the pipe 22-1, the mass flow controller 24-1, the pipe 25-1, the vapourizer 27-1 and the pipe 28-1 respectively, as hereinbefore described. Furthermore, any number of similar raw material supply systems may be provided.

The vapourizer 27-1 may be connected with other liquid systems containing raw material and which may have similar structure as those of the liquid container 21-1, the pipe 22-1, the Mass Flow Controller 24-1 and the pipe 25-1. Other vapourizers may also be provided with any number of the raw liquid material supply systems.

A reaction chamber 30 has raw material pipes such as a gas pipe 29 and the raw liquid material pipes 28-1, 28-2..., and can supply raw material gas from a showerhead 32. A susceptor 34 capable fo controlling the temperature is disposed at a lower portion of the reaction chamber 30. A substrate 35 composed of, for example, a silicon base layer provided with a silicon oxide layer is disposed on the susceptor 34.

The above described embodiment is not limited to multiple supply systems and a single system may be employed. Furthermore, a plurality of the reaction chambers may also be provided.

With regard to an organometallic material contained in the liquid containers, for example, an Mg raw material, a solution may be obtained by dissolving Mg(DPM)₂ where DPM is dipivaloilmethanate) in tetrahydrofuran (THF).

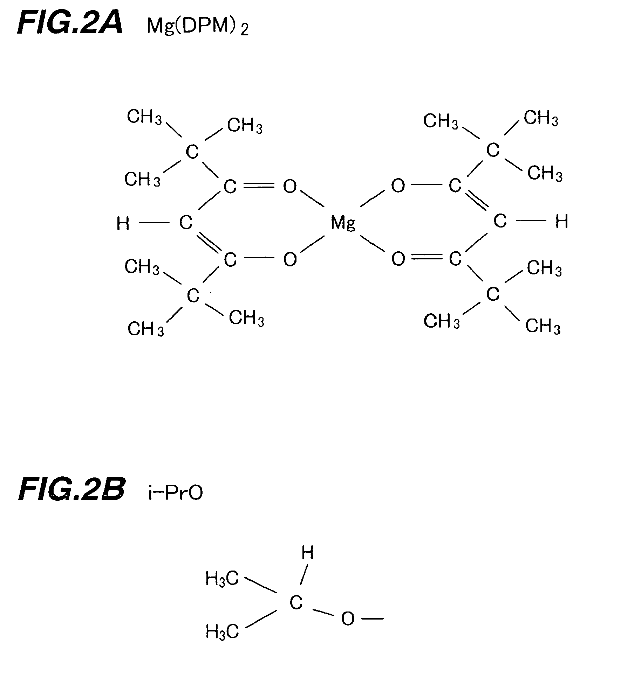

Fig. 2A is a chemical formula showing the chemical structure of Mg(DPM)₂. Dipivaloilmethanate (DPM) is bonded through an oxygen atom at each side of an Mg atom. DPM is monovalent but forms a coordinate bond via its carbonyl group to form a chelate with the Mg atom.

n DPM's may be bonded to an n valent atom, so that in this case for every one Mg, there are two DPMs bonded thereto. If an Re material is used, then a solution may be obtained by dissolving Re(DPM)₂ in THF. The chemical structure of Re(DPM)₂ is equivalent to that of Mg(DPM)₂ as shown in Fig. 2A.

If a Pb material is used, a solution may then be obtained by dissolving Pb(DPM)₂ in THF. The structure of Pb(DPM)₂ is equivalent to that of Mg(DPM)₂ as shown in Fig. 2A.

If a Zr material is used, then a solution may be obtained by dissolving Zr(DPM)₄ in THF Zr(DPM)₄ has a different structure to that of the aforementioned chelates, whereby four DPMs are bonded around one Zr atom.

If a Ti material is used, then a solution may be obtained by dissolving Ti (i-PrO)₂(DPM)₂ (where i-PrO is an iso-propoxy group) in THF. The structure of Ti (i-PrO)₂(DPM)₂ is equivalent to that of Mg(DPM)₂ as shown in Fig. 2A, but also binds with two iso-propoxy groups, as shown in Fig. 2B, to Ti. Note that the organometallic material is not limited to these examples.

In order to deposit the MgO layer 12 shown in Fig. 1A, pressurized helium (He) gas is fed to the liquid containers 21 in which the solution obtained by dissolving Mg(DPM)₂ in THF is contained. The solution is vapourised by passing it through the vapourizers 27 at 260°C, and loaded into the carrier gas N₂.

The Mg raw material is fed through the pipes 28 to the showerhead 32 by means of an N₂ carrier gas, and carried over the silicon oxide film of the substrate 35 together with O₂ gas supplied from the pipe 29. The silicon oxide film is then heated to 560°C, whereby it decomposes the organometallic gas present. The decomposed gas combines with the oxygen, thus precipitating MgO and forming a (001)-oriented MgO layer deposited on the silicon oxide film. The thickness of the (001)-oriented MgO layer is set, for example, in a range from 50 to 100 nm.

The temperature is not limited to 560°C. Preferably, decomposition of the organometallic gas is carried out with a substrate temperature of 620°C or below, which may enable temperature compatibilities with other manufacturing steps for the production of the FeRAM device.

In order to deposit the ReO₃ layer 13 on the (001)-oriented MgO layer 12, the liquid raw material obtainable by dissolving Re(DPM)₂ in THF, which is contained in the liquid containers 21, is fed to the showerhead 32 by means of a carrier gas in the same manner as the process hereinbefore described. The showerhead 32 is supplied with O₂ gas, mixed gas of O₂ gas and N₂ gas or the like. Other mixed O₂ gases may include O₂/Ar, O₂/He and O₂/N₂O.

The substrate 35 having the (001)-oriented MgO layer 12 formed thereon is kept at a constant temperature of 560°C by means of the susceptor 34. The raw material gas is supplied to the heated (001)-oriented MgO layer 12 whereby a (001)-oriented ReO₃ layer 13 is deposited thereon. The thickness of the (001)-oriented ReO₃ layer may be set, for example, in a range from 20 to 50 nm.

After the (001)-oriented ReO₃ layer 13 is deposited, the PZT layer 14 is deposited thereon. For the PZT, the Pb solution is obtained by dissolving Pb(DPM)₂ in THF, the Zr solution is obtained by dissolving Zr(DPM)₄ in THF, and the Ti solution is obtained by dissolving Ti (i-PrO)₂(DPM)₂ in THF. Pressurized helium gas is fed into three liquid containers containing these liquid raw materials, and the liquid raw materials are vapourized by one or three vapourizers and supplied to the showerhead 32.

The substrate temperature is kept at 560°C, and gaseous Pb(DPM)₂, Zr(DPM)₄ and Ti(i-PrO)₂(DPM)₂ together with oxygen are simultaneously blown over the substrate, as a result of which the Pb(Zr, Ti)O₃ (PZT) layer 14 is deposited on the (001)-oriented ReO₃ layer 13. The deposited PZT layer 14 also has (001) orientation. The thickness of the (001)-oriented PZT layer 14 may be set, for example, in a range from 80 to 150 nm.

Other ferroelectric oxide materials having a perovskite structure may also be employed. For example, Pb_{y}La_{1-y}ZrₓTi₁₋ₓO₃ (PLZT), Pb_{1-a-b-c}LaₐSr_{b}Ca_{c}Zr₁₋ₓTiₓO₃ (PLSCZT) and the like can be used.

As described above, an MgO layer is deposited on an amorphous silicon oxide layer 11 by MOCVD, in order to obtain a (001)-oriented MgO layer 12. On the (001)-oriented MgO layer 12, there can be deposited a ReO₃ layer 13, which is (001)-oriented in accordance with the orientation of the underlying layer, that is, the MgO layer 12. Furthermore, the PZT layer 14, can be deposited on the (001)-oriented ReO₃ layer 13, the PZT layer 14 being (001)-oriented in accordance with the orientation of the underlying layers, that is, the MgO layer 12 and the ReO₃ layers 13.

An upper electrode 15 is formed on the PZT layer 14. The upper electrode 15 is not required to be (001)-oriented and can be formed one of various known electrode materials irrespective of the orientation of the ferroelectric layer. For example, an IrO₂ layer may be deposited by MOCVD, in which case an Ir solution obtained by dissolving Ir(DPM)₃ in THF is used. The process for vapourizing the material is similar as that as hereinbefore described. The substrate temperature is kept at 560°C, and, e.g. Ir(DPM)₃ gas, and oxygen are simultaneously blown thereover, thus enabling the upper IrO₂ electrode 15 or IrO₂ layer to be deposited on the PZT layer 14. The thickness of the IrO₂ layer 15 may be set, for example, in a range from 100 to 150 nm.

As shown in Fig. 1C, for the upper electrode, a stacked layer 15 obtained by stacking an IrO₂ layer 15-1 and a SrRuO₃ layer 15-2 may be used. Deposition methods other than MOCVD may also be used. For example, the IrO₂ layer 15-1 can be deposited by sputtering using an IrO₂ target. In this case, the substrate is kept at a room temperature, and the target is sputtered by use of Ar gas under a vacuum of 3x10⁻⁴ Torr. The thickness of the IrO₂ layer 15-1 may be set, for example, in a range from 100 to 150 nm.

The SrRuO₃ layer 15-2, being deposited on the IrO₂ layer 15-1, can also be deposited by sputtering. SrRuO₃ is used as a target, the substrate is kept at a room temperature, the vacuum is set at 3x10⁻⁴ Torr under Ar gas. Under the above-described conditions, the target is sputtered, and thus the SrRuO₃ layer 15-2 is deposited. The thickness of the SrRuO₃ layer 15-2 may be set, for example, in a range from 10 to 30 nm.

A metal layer used as an electrode may be utilized effectively as long as an electrical resistivity thereof is 10⁻⁵ Ω·m or less. ReO₃, in the presence of a small amount of another metal shows an electrical resistance of an order of 10⁻⁶ Ω·m at 300°K.
Accordingly, ReO₃, with other metal impurities can still be utilized effectively as such an electrode of the ferroelectric capacitor.

Fig. 1D shows the case where a ReO₃ layer 13 and a ferroelectric layer 14 having a perovskite structure, are epitaxially grown in this order on a single crystal MgO layer 12 having a (001) plane, an upper electrode 15 being formed on the ferroelectric layer 14.

Furthermore, it will be possible to deposit the (001)-oriented MgO layer 12, ReO₃ layer 13 and ferroelectric layer 14 respectively, using, in place of Chemical Vapour Deposition (CVD) using the organometallic raw materials, CVD using other raw materials. Similarly, it will be possible to deposit the above (001)-oriented layers by sputtering.

The ferroelectric layer 14 is (001)-oriented, thus enabling the polarization caused by an applied voltage to be aligned to a direction perpendicular to the electrode surface, thus utilising the polarization of the ferroelectric layer in an efficient manner.

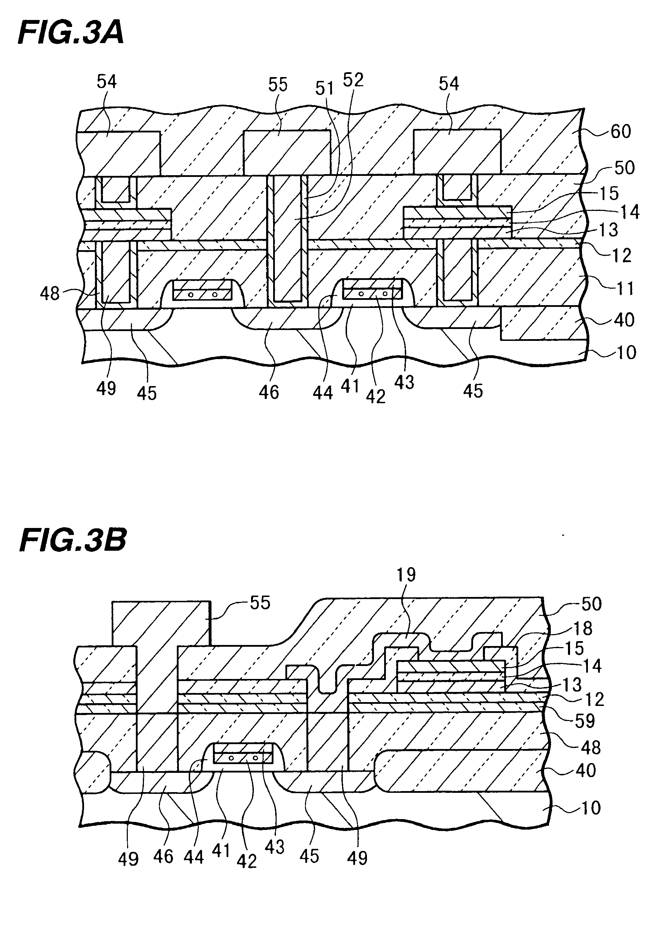

Figs. 3A and 3B show examples of arrangements of electronic devices, each using the ferroelectric capacitor as hereinbefore described.

Fig.3A shows an example where electrodes (extension electrodes hereinafter) extend out of upper and lower surfaces of a ferroelectric capacitor. An element isolation region 40 is formed on a surface of an Si substrate 10 by Shallow Trench Isolation (STI). Two Metal-Oxide-Semiconductor (MOS) transistors are formed in an active region, defined by the element isolation region 40. The two MOS transistors have one common source/drain region 46 and other separate source/drain regions 45 on both sides which are connected with the ferroelectric capacitors, respectively.

An insulated gate electrode formed of a gate insulating film 41, a polycrystalline gate electrode 42 and a silicide gate electrode 43 are disposed along connecting channels between the source/drain regions. A side spacer 44 is formed on a sidewall of the insulated gate electrode 43. An amorphous insulating layer 11 made of silicon oxide or the like is formed over surfaces where the semiconductor devices are located. Furthermore, a (001)-oriented MgO layer 12 is formed on a surface of the amorphous insulating layer 11.

In order to form an extraction electrode for each of the source/drain regions 45, a contact hole is formed through the MgO layer 12 and through the amorphous insulating layer 11. An extraction plug composed of, for example, a barrier metal 48 and a tungsten (W) plug 49 is formed in the contact hole. Then, the electrode layers on the MgO layer 12 which are no longer required, are removed by, for example, Chemical Mechanical Polishing (CMP).

Subsequently, on the MgO layer 12, is formed a ferroelectric capacitor composed of the lower ReO₃ layer 13, the ferroelectric layer 14 having a perovskite structure 14 and finally, the upper electrode 15.

The MgO layer 12 is (001)-oriented, thus making it possible to form the (001)-oriented lower ReO₃ layer 13 and the (001)-oriented ferroelectric layer 14 having a perovskite structure.

After forming the ferroelectric capacitor, an insulating layer 50 made of silicon oxide or the like is deposited to cover the outer surface thereof. A contact hole is formed through the insulating layer 50, and then a barrier metal layer 51 and a metal conductive layer 52 made of W or the like are buried therein, thus the extraction electrode is formed. After forming the extraction electrode, unnecessary electrode layers on the insulating layer 50 are removed, and upper wirings 54 and 55 are formed. Surfaces of the upper wirings 54 and 55 are covered with an insulating layer 60.

Fig. 3B shows an arrangement, in which two electrodes extend out of the upper surface of the ferroelectric capacitor. An element isolation region 40 of silicon oxide film is formed on the surface of the Si substrate 10 by the local oxidation of silicon. One MOS transistor is formed in an active region defined by the element isolation region 40. An insulated gate electrode formed of a gate insulating film 41, a polycrystalline gate electrode 42 and a polycrystalline silicide gate electrode 43 are disposed in a channel region of the arrangement. A side spacer 44 is formed on a sidewall of the insulated gate electrode. Source/drain regions 45 and 46 are formed on both sides of the gate electrode by ion implantation and the like.

An amorphous insulating layer 48 made of silicon oxide or the like is formed to cover the MOS transistor. Plugs 49 for providing the source/drain regions 45 and 46 are formed. A layer 59, for example silicon nitride, having an amorphous phase is formed on a surface of the amorphous insulating layer 48 through which the plugs 49 project, thus forming an oxygen shielding layer.

On the amorphous silicon nitride layer 59, a (001)-oriented MgO layer 12 is formed. It is conceivable that the (001)-oriented MgO layer 12 may only be deposited upon an underlying amorphous layer. A ferroelectric capacitor composed of a (001)-oriented ReO₃ layer 13, a (001)-oriented ferroelectric layer 14 having a perovskite structure and an upper electrode 15 are formed on the (001)-oriented MgO layer 12. The lower ReO₃ electrode 13 is extrapolated along a direction perpendicular to the electrode surface. An insulating layer 18 made of silicon oxide or the like is formed to cover the ferroelectric capacitor.

Desired portions of the insulating layer 18, MgO layer 12 and silicon nitride layer 59 are removed by etching, to form contact holes, in which wiring 19 connects the plug 49 exposed in the contact hole with the upper electrode 15. An insulating layer 50 is further formed to cover the local wiring 19. Through the insulating layer 50, a second opening for exposing the plug 49 on the source/drain region 46 is formed into which a second wiring 55 is arranged.

The arrangements shown in Figs. 3A and 3B, are examples, and are not limiting. Various alternatives and replacements may be employed. Multi-layered wiring structures can be formed by other publicly known techniques. As described above, an electronic device for example, a semiconductor integrated circuit device can be manufactured with the ferroelectric capacitor.

## Claims

1. An electronic device comprising:
an underlying body (11, 12) including an amorphous layer (11) and a MgO layer (12), said MgO layer (12) being formed on said amorphous layer (11) and having a (001) orientated surface;
a ReO₃ layer (13) formed on said MgO layer (12) and having a (001) orientation; and
an oxide ferroelectric layer (14) having a perovskite structure, said oxide ferroelectric layer (14) being formed on said ReO₃ layer (13) and having a (001) orientation.

2. The electronic device according to claim 1, wherein the amorphous layer (11) comprises silicon oxide.

3. The electronic device according to claim 1 or 2, further comprising: an upper electrode (15) formed on said oxide ferroelectric layer (14).

4. The electronic device according to any preceding claim, wherein said amorphous layer (11) forms an insulating layer, wherein said amorphous layer (11) encapsulates a semiconductor element formed on a semiconductor substrate (10) and a conductive plug (49) is provided to electrically connect said semiconductor element, said conductive plug (49) penetrating through said insulating layer (11).

5. The electronic device according to claim 4, wherein a ferroelectric capacitor is formed over said conductive plug (49), said ferroelectric capacitor comprising a lower ReO₃ layer (13), a ferroelectric layer (14) and an upper electrode (15).

6. The electronic device according to claim 5, further comprising:
a second insulating layer (50) covering said ferroelectric capacitor (13, 14, 15);
a plurality of apertures penetrating through said second insulating layer (50) and exposing said conductive plug (49) and said upper electrode (15); and
said conductive plug (49) and said upper electrode (15) being connected via said apertures by local wiring (54).

7. The electronic device according to any preceding claim, wherein said ReO₃ layer (13) is added with metal other than Re.

8. The electronic device according to any one of claims 3 to 7, wherein said upper electrode (15) is formed:of an IrO₂ layer, or a stack of an IrO₂ layer and a SrRuO₃ layer.

9. The electronic device according to any preceding claim, wherein said ferroelectric layer (14) is PZT.

10. The electronic device according to any one of claims 4 to 9, wherein said conductive plug (49) is tungsten.

11. A method of manufacturing an electronic device, comprising the sequential steps of:
(1) preparing an amorphous layer (11);
(2) forming a MgO layer (12) having an (001) orientation on said amorphous layer (11);
(3) forming a ReO₃ layer (13) having a (001) orientation on said MgO layer (12); and
(4) forming an oxide ferroelectric layer (14), having a perovskite structure and a (001) orientation, on said ReO₃ layer (13).

12. The method of manufacturing an electronic device according to claim 11, wherein the amorphous layer (11) comprises silicon oxide.

13. The method of manufacturing an electronic device according to claim 11 or 12, wherein at least one of said steps (2), (3) and (4) is executed by Organometallic Chemical Vapour Deposition (MOCVD).

14. The method of manufacturing an electronic device according to claim 11 or 12, wherein all of said steps (2), (3) and (4) are executed by MOCVD.

15. The method of manufacturing an electronic device according to claim 13 or 14, wherein said MOCVD is executed at a substrate temperature of 620°C or lower.

16. The method of manufacturing an electronic device according to any one of claims 13 to 15, wherein an organometallic raw material for use in said MOCVD comprises a dipivaloilmethanate (DPM) - metal chelate or an iso-propoxy (i-PrO) bound metal.

17. The method of manufacturing an electronic device according to claim 11 or 12, wherein at least one of said steps (2), (3) and (4) is executed by sputtering.

18. The method of manufacturing an electronic device according to any one of claims 11 to 17, further comprising the step of: (5) forming at least one upper electrode layer (15) on said oxide ferroelectric layer (14).

19. The method of manufacturing an electronic device according to any one of claims 11 to 18, further comprising the step of forming a conductive plug (49) through said amorphous layer (11).

## Patentansprüche

1. Eine elektronische Vorrichtung enthaltend:
einen Grundkörper (11, 12), der eine amorphe Schicht (11) und eine MgO-Schicht (12) enthält, wobei die MgO-Schicht (12) auf der amorphen Schicht (11) ausgebildet ist und eine (001)-orientierte Oberfläche aufweist;
eine ReO₃-Schicht (13), die auf der MgO-Schicht (12) ausgebildet ist und eine (001)-Orientierung aufweist; und
eine ferroelektrische Oxidschicht (14) mit einer Perovskitstruktur, wobei die ferroelektrische Oxidschicht (14) auf der ReO₃-Schicht (13) ausgebildet ist und eine (001)-Orientierung aufweist.

2. Die elektronische Vorrichtung nach Anspruch 1, wobei die amorphe Schicht (11) Siliziumoxid enthält.

3. Die elektronische Vorrichtung nach Anspruch 1 oder 2, weiter enthaltend: eine obere Elektrode (15), die auf der ferroelektrischen Oxidschicht (14) ausgebildet ist.

4. Die elektronische Vorrichtung nach einem der vorhergehenden Ansprüche, wobei die amorphe Schicht (11) eine Isolierschicht ausbildet, wobei die amorphe Schicht (11) ein Halbleiterelement umhüllt, das auf einem Halbleitersubstrat (10) ausgebildet ist, und wobei ein leitender Stecker (49) bereitgestellt ist, um das Halbleiterelement elektrisch anzuschließen, wobei der leitfähige Stecker (49) durch die Isolierschicht (11) hindurchreicht.

5. Die elektronische Vorrichtung nach Anspruch 4, wobei ein ferroelektrischer Kondensator über dem leitenden Stecker (49) ausgebildet ist, wobei der ferroelektrische Kondensator eine untere ReO₃-Schicht (13), eine ferroelektrische Schicht (14) und eine obere Elektrode (15) enthält.

6. Die elektronische Vorrichtung nach Anspruch 5, weiter enthaltend:
eine zweite Isolierschicht (50), die den ferroelektrischen Kondensator (13, 14, 15) bedeckt;
eine Mehrzahl an Öffnungen , die durch die zweite Isolierschicht (50) hindurchreichen und den leitenden Stecker (49) und die obere Elektrode (15) freilegen; und
wobei der leitende Stecker (49) und die obere Elektrode (15) über die Öffnungen durch eine lokale Verdrahtung (54) angeschlossen sind.

7. Die elektronische Vorrichtung nach einem der vorhergehenden Ansprüche, wobei der ReO₃-Schicht (13) ein von Re verschiedenes Metall hinzugefügt ist.

8. Die elektronische Vorrichtung nach einem der Ansprüche 3 bis 7, wobei die obere Elektrode (15) aus einer IrO₂-Schicht ausgebildet ist, oder einem Stapel aus einer IrO₂-Schicht und einer SrRuO₃-Schicht.

9. Die elektronische Vorrichtung nach einem der vorhergehenden Ansprüche, wobei die ferroelektrische Schicht (14) PZT ist.

10. Die elektronische Vorrichtung nach einem der Ansprüche 4 bis 9, wobei der leitende Stecker (49) Wolfram ist.

11. Ein Verfahren zum Herstellen einer elektronischen Vorrichtung, das die aufeinander folgenden Schritte enthält:
(1) Herstellen einer amorphen Schicht (11);
(2) Ausbilden einer MgO-Schicht (12) mit einer (001)-Orientierung auf der amorphen Schicht (11);
(3) Ausbilden einer ReO₃-Schicht (13) mit einer (001)-Orientierung auf der MgO-Schicht (12); und
(4) Ausbilden einer ferroelektrischen Oxidschicht (14) mit einer Perovskitstruktur und einer (001)-Orientierung auf der ReO₃-Schicht (13).

12. Das Verfahren zum Herstellen einer elektronischen Vorrichtung nach Anspruch 11, wobei die amorphe Schicht (11) Siliziumoxid enthält.

13. Das Verfahren zum Herstellen einer elektronischen Vorrichtung nach Anspruch 11 oder 12, wobei wenigstens einer der Schritte (2), (3) und (4) durch metallorganische chemische Dampfabscheidung (MOCVD) durchgeführt wird.

14. Das Verfahren zum Herstellen einer elektronischen Vorrichtung nach Anspruch 11 oder 12, wobei alle Schritte (2), (3) und (4) durch MOCVD durchgeführt werden.

15. Das Verfahren zum Herstellen einer elektronischen Vorrichtung nach Anspruch 13 oder 14, wobei die MOCVD bei einer Substrattemperatur von 620°C oder niedriger durchgeführt wird.

16. Das Verfahren zum Herstellen einer elektronischen Vorrichtung nach einem der Ansprüche 13 bis 15, wobei ein metallorganisches Ausgangsmaterial zur Verwendung in der MOCVD ein Dipivaloilmethanat-Metallchelat (Dipivaloilmethanat = DPM) oder ein an Iso-Propoxy (i-PrO) gebundenes Metall enthält.

17. Das Verfahren zum Herstellen einer elektronischen Vorrichtung nach Anspruch 11 oder 12, wobei wenigstens einer der Schritte (2), (3) und (4) durch Sputtern durchgeführt wird.

18. Das Verfahren zum Herstellen einer elektronischen Vorrichtung nach einem der Ansprüche 11 bis 17, das weiter den Schritt enthält: (5) Ausbilden von wenigstens einer oberen Elektrodenschicht (15) auf der ferroelektrischen Oxidschicht (14).

19. Das Verfahren zum Herstellen einer elektronischen Vorrichtung nach einem der Ansprüche 11 bis 18, weiter enthaltend den Schritt des Ausbildens eines leitenden Steckers (49) durch die amorphe Schicht (11) hindurch.

## Revendications

1. Dispositif électronique comprenant :
un corps sous-jacent (11, 12) incluant une couche amorphe (11) et une couche de MgO (12), ladite couche de MgO (12) étant formée sur ladite couche amorphe (11) et ayant une surface orientée (001) ;
une couche de ReO₃ (13) formée sur ladite couche de MgO (12) et ayant une orientation (001) ; et
une couche d'oxyde ferroélectrique (14) ayant une structure pérovskite, ladite couche d'oxyde ferroélectrique (14) étant formée sur ladite couche de ReO₃ (13) et ayant une orientation (001).

2. Dispositif électronique selon la revendication 1, dans lequel la couche amorphe (11) comprend un oxyde de silicium.

3. Dispositif électronique selon la revendication 1 ou 2, comprenant en outre : une électrode supérieure (15) formée sur ladite couche d'oxyde ferroélectrique (14).

4. Dispositif électronique selon l'une quelconque des revendications précédentes, dans lequel ladite couche amorphe (11) forme une couche isolante, dans lequel ladite couche amorphe (11) encapsule un élément semi-conducteur formé sur un substrat semi-conducteur (10) et une fiche conductrice (49) est fournie pour connecter électriquement ledit élément semi-conducteur, ladite fiche conductrice (49) pénétrant à travers ladite couche isolante (11).

5. Dispositif électronique selon la revendication 4, dans lequel un condensateur ferroélectrique est formé sur ladite fiche conductrice (49), ledit condensateur ferroélectrique comprenant une couche de ReO₃ inférieure (13), une couche ferroélectrique (14) et une électrode supérieure (15).

6. Dispositif électronique selon la revendication 5, comprenant en outre :
une seconde couche isolante (50) recouvrant ledit condensateur ferroélectrique (13, 14, 15) ;
une pluralité d'ouvertures pénétrant à travers ladite seconde couche isolante (50) et exposant ladite fiche conductrice (49) et ladite électrode supérieure (15) ; et
ladite fiche conductrice (49) et ladite électrode supérieure (15) étant connectées via lesdites ouvertures par un câblage local (54).

7. Dispositif électronique selon l'une quelconque des revendications précédentes, dans lequel ladite couche de ReO₃ (13) est ajoutée avec un métal autre que Re.

8. Dispositif électronique selon l'une quelconque des revendications 3 à 7, dans lequel ladite électrode supérieure (15) est formée d'une couche de IrO₂, ou d'un empilage d'une couche de IrO₂ et d'une couche de SrRuO₃.

9. Dispositif électronique selon l'une quelconque des revendications précédentes, dans lequel ladite couche ferroélectrique (14) est une PZT (céramique en Titano-Zirconiate de Plomb).

10. Dispositif électronique selon l'une quelconque des revendications 4 à 9, dans lequel ladite fiche conductrice (49) est en tungstène.

11. Procédé de fabrication d'un dispositif électronique, comprenant les étapes séquentielles consistant à :
(1) préparer une couche amorphe (11);
(2) former une couche de MgO (12) ayant une orientation (001) sur ladite couche amorphe (11) ;
(3) former une couche de ReO₃ (13) ayant une orientation (001) sur ladite couche de MgO (12); et
(4) former une couche d'oxyde ferroélectrique (14) ayant une structure pérovskite et une orientation (001) sur ladite couche de ReO₃ (13).

12. Procédé de fabrication d'un dispositif électronique selon la revendication 11, dans lequel la couche amorphe (11) comprend un oxyde de silicium.

13. Procédé de fabrication d'un dispositif électronique selon la revendication 11 ou 12, dans lequel au moins une desdites étapes (2), (3) et (4) est réalisée par dépôt chimique en phase vapeur à partir de précurseurs organométalliques (MOCVD).

14. Procédé de fabrication d'un dispositif électronique selon la revendication 11 ou 12, dans lequel toutes lesdites étapes (2), (3) et (4) sont réalisées par MOCVD.

15. Procédé de fabrication d'un dispositif électronique selon la revendication 13 ou 14, dans lequel ledit MOCVD est réalisé à une température de substrat de 620 °C ou inférieure.

16. Procédé de fabrication d'un dispositif électronique selon l'une quelconque des revendications 13 à 15, dans lequel la matière première organométallique à utiliser dans ledit MOCVD comprend un méthanate de dipivaloyle (DPM) - chélate de métal ou un métal lié à un groupe iso-propoxy (i-PrO).

17. Procédé de fabrication d'un dispositif électronique selon la revendication 11 ou 12, dans lequel au moins l'une desdites étapes (2), (3) et (4) est réalisée par pulvérisation cathodique.

18. Procédé de fabrication d'un dispositif électronique selon l'une quelconque des revendications 11 à 17, comprenant en outre l'étape consistant à : (5) former au moins une couche d'électrode supérieure (15) sur ladite couche d'oxyde ferroélectrique (14).

19. Procédé de fabrication d'un dispositif électronique selon l'une quelconque des revendications 11 à 18, comprenant en outre l'étape consistant à former une fiche conductrice (49) à travers ladite couche amorphe (11).
